# EUROPEAN PATENT APPLICATION

(11) **EP 1 746 629 A1**
(43) Date of publication of application: **24.01.2007**
(21) Application number: 05015981.3
(22) Date of filing: 22.07.2005
(51) Int. Cl.: H01J 37/02, H01J 37/06, H01J 37/073

(54) **Field emitter arrangement and method of cleansing an emitting surface of a field emitter**

(71) Applicant: ICT, Integrated Circuit Testing Gesellschaft für Halbleiterprüftechnik Mbh, 85551 Heimstetten (DE)
(72) Inventor: Adamec, Pavel, 85540 Haar (DE); Zhou, Fang, 85652 Pliening/Landsham (DE)
(74) Representative: Zimmermann & Partner

(57) **Abstract**

A field emitter arrangement (100) is provided, said field emitter arrangement (100) including: a field emitter tip (10) having an emitting surface (11), wherein said field emitter tip (10) is adapted to generate a primary beam (15) of charged particles, and at least one electron source (20) adapted to illuminate the emitting surface (11) of the field emitter tip (10).

## Description

### FIELD OF THE INVENTION

The invention relates to a field emitter arrangement as well as to a method of cleansing an emitting surface of a field emitter.

### BACKGROUND OF THE INVENTION

Technologies like microelectronics, micromechanics and biotechnology have created a high demand in industry for structuring and probing specimens within the nanometer scale. On such a small scale, probing or structuring, e.g. of photomasks, is often done with electron beams which are generated and focused in electron beam devices like electron microscopes or electron beam pattern generators. Electrons beams offer superior spatial resolution compared to e.g. photon beams due to their short wave lengths at a comparable particle energy.

The first step in the process of creating images in any electron microscope is the production of an electron beam. The electron beam is generated in a device often called an electron gun. Three major types of electron guns are used in electron microscopes: tungsten-hairpin filament guns, lanthanum-hexaboride guns, and field-emission guns. Field-emission guns offer several advantages over tungsten-hairpin filament guns or lanthanum-hexaboride guns: First, the brightness may be up to a thousand times greater than that of a tungsten gun. Second, the electrons are emitted from a point more narrow than that in the other sources. Thus, superior resolution is achieved by field-emission guns. Furthermore, the energy spread of the emitted electrons is comparatively small. Finally, the field-emission gun has a very long lifetime. For these reasons, the field-emission gun is the preferred choice for a number of applications.

There exist three major types of field emission guns: cold field emission guns, thermal field emission guns and Schottky emitters. While cold field emission guns rely on the pure field emission effect, thermal field emission guns enhance the pure field emission effect by giving some thermal energy to the electrons in the metal, so that the required tunneling distance is shorter for successful escape from the surface. A Schottky emitter is a thermal field emitter that has been further enhanced by doping the surface of the emitter to reduce the work function.

The cold field emitter tip has the highest brightness of presently known emitters and is therefore the preferred choice for obtaining highest possible electron density in the smallest spot. Thus, electron microscopes equipped with cold cathode emitters are superbly suited to obtain high resolution, high quality images - especially at very low acceleration voltages. Extra advantages of cold emitters are their long lifetime and ease of use, which reduces the cost of ownership.

However, during operation continual adsorption and occasional desorption of residual gas molecules occurs on the emitting surface of cold field electron emitters. These adsorptions and desorptions lead to continuously degraded and momentarily instable emission current, respectively, so that the emitting surface has to be cleaned in regular intervals. Conventionally, this is done by a so-called "flashing" method. According to the flashing method, a heating current is supplied to the emitter so that the emitting surface heats up and the debris is removed from the surface. Heating the tip momentarily (flashing) can clean it, but new atoms and molecules quickly readsorb even in the best of vacuums. In addition, atoms may be ionized by the electron beam and subsequently accelerated back into the tip, causing physical sputtering of the tip itself. To minimize the current fluctuations, the electron source must be operated in an extreme ultra high vacuum environment, 10⁻¹⁰ Torr or better. Further to this, the use of the electron microscope has to be suspended during the flashing process which may take some minutes or even longer. This reduces the effective working time of the microscope and is especially undesirable in high through-put applications like wafer inspection or the like.

### SUMMARY OF THE INVENTION

In view of the above, a field emitter arrangement including a field emitter with an emitting surface is provided, said field emitter being adapted to generate a primary beam of charged particles, and at least one electron source adapted to illuminate the emitting surface of the field emitter. Also, a charged particle beam apparatus including such a field emitter arrangement is provided. Furthermore, a method of cleaning an emitting surface of a field emitter is provided, the method including the steps of providing a field emitter with an emitting surface and an electron source adapted for illuminating the emitting surface, and illuminating the emitting surface of the field emitter with an electron beam generated by the electron source.

Further advantages, features, aspects and details of the invention are evident from the claims, the description and the accompanying drawings.

According to a first aspect, a field emitter arrangement is provided which comprises a field emitter with an emitting surface. The field emitter can generate a primary beam of charged particles, typically an electron beam. Furthermore, the field emitter arrangement comprises at least one electron source which is adapted to illuminate the emitting surface of the field emitter. For this purpose, the at least one electron source may be a ring-shaped emitter disposed around an extractor electrode of the field emitter. According to an alternative embodiment, the at least one electron source may comprise one or more concentrated electron emitters. In this context, the term "concentrated" does not only refer to concentrated emitters but refers to all emitters with a reduced, i.e. concentrated, emission area. Furthermore, the extractor electrode of the field emitter may then have one or more openings facing a respective one of the concentrated electron emitters as well as the emitting surface of the field emitter so that one or more electron beams generated by the one or more electron sources, respectively, can pass through the openings and illuminate the emitting surface of the field emitter.

Electrons can desorb gas molecules from metal surfaces, particularly in vacuum. Therefore, the emitting surface of the emitter tip may be kept continuously clean by illuminating it with an electron beam. Furthermore, the incident electron beam can be adjusted so that it does not interfere with the operation of the charged particle beam apparatus. Particularly, the landing energy of the electrons can be variably adjusted, e.g. from a few hundred eV up to a few keV. Thus, the emitting surface of the emitter tip can be continuously kept clean so that a stable electron beam is emitted. Furthermore, the operation of the charged particle beam apparatus has not to be suspended during the cleaning.

According to another embodiment, a plurality of electron emitters is arranged in a ring-like pattern around the emitting surface. Thus, uniform illumination of the emitting surface is provided when using concentrated emitters as electron sources.

According to a further embodiment, the at least one electron source is integrated into the field emitter. Thus, it is possible to manufacture the field emitter for the primary electron beam together with the electron source or the electron sources, respectively, used for cleansing of the emitting surface. The number of parts within a charged particle apparatus can thus be reduced. Furthermore, the same circuitry for voltage and current control can be used for the main field emitter and the cleansing electron sources.

According to still another embodiment, the field emitter arrangement is adapted such that an electron beam generated by the at least one electron source impinges on the emitting surface in a direction essentially normal to the emitting surface. Thus, only the tip of the emitter is illuminated and a relatively low beam current density of, e.g., only one-tenth of the primary beam current density is sufficient for cleaning the emitter tip. A low beam current density of the cleansing beam reduces the number of secondary electrons generated at the emitter surface by the cleansing beam. If the cleansing electron beam is laterally incident on the field emitter, a larger surface area has to be illuminated to guarantee that the emitter tip is sufficiently illuminated. Therefore, a higher beam current density must be provided in this case. Furthermore, the illumination uniformity is higher if the cleansing beam impinges essentially normal onto the emitter surface.

According to still a further embodiment, a beam separation device is provided. By means of the beam separation device, the electron beam generated by the at least one electron source can be redirected so that the electron beam impinges on the emitting surface in a direction essentially normal to the emitting surface. Typically, the beam separation is realized by a magnetic dipole field or a magnetic sector field of the Wien filter type. However, any other kind of beam separating device can be used for directing the cleaning beam so that it hits the emitting surface perpendicularly.

Due to the beam separation device, it is not necessary that the electron source directly faces the emitting surface. Therefore, the electron source can be variably placed within a charged particle beam apparatus according to the requirements of a specific application. Furthermore, the cleansing beam can be effectively controlled by the beam separation element. For example, the beam separation device allows focusing of the cleansing beam, i.e. to reduce its cross section, and also allows accurate positioning of the cleansing beam on the field emitter. Thus, the cleansing beam may be adjusted to illuminate only the emitter tip where the primary electron beam is generated.

According to even a further embodiment, the beam separation device redirects the cleansing electron beam so that the cleansing electron beam is essentially coaxial with the optical axis of the field emitter.

Thus, the cleansing electron beam impinges normally onto the emitting surface of the field emitter, i.e. the front face of the emitter tip where the primary electron beam is generated. Furthermore, the cleansing beam may enter through the same opening of the extractor electrode through which the primary beam generated by the field emitter exits. Thus, no adaptation of the extractor electrode is necessary, i.e. the present invention can be carried out with a conventional extractor electrode having a single opening.

According to even another embodiment, the average electron energy of electrons within the electron beam generated by the at least one electron source can be controlled within a certain range.

Thus, the average electron energy can be adjusted so that a beam separation device can separate the cleansing beam from a primary beam, e.g. for wafer inspection. Furthermore, the average electron energy within the cleansing beam can be adjusted so that only very few secondary electrons are generated at the emitting surface by the cleansing beam. Typically, the average electron energy varies between a few hundred eV and a few keV, e.g. between 100 eV and 50 keV. Typically, also the beam current density of the cleansing beam is adjustable and will be typically adjusted in relation to the beam current density of the primary beam. Typically, the beam current density of the cleansing beam will be adjusted so that more field-emitted electrons are produced than secondary electrons. Typically, a ratio of 2:1 between primary electrons (field-emitted electrons) and secondary electrons will be selected, or even a ratio of 5:1 1 or 10:1. However, the beam current density of the cleansing beam depends on the direction of incidence onto the field emitter. When the cleansing beam impinges frontal onto the emitter tip, it may be sufficient for the cleansing beam to have only one-tenth of the primary beam current density. However, if the cleansing beam impinges laterally onto the emitter tip, a much higher beam current density may be required, even considerably higher than the beam current density of the primary beam.

According to another embodiment, an energy filter, e.g. a Wien filter, is provided. By means of this energy filter, secondary electrons which are generated at the emitting surface by the impinging cleansing electron beam, can be removed from the primary electron beam generated by the field emitter. In other words, the secondary electrons can be separated from the field-emitted electrons by use of the energy filter, especially when the production rate of secondary electrons is too high compared to the production rate of primary electrons.. This is due to the fact that the secondary electrons have a higher average energy and a much broader energy distribution than the field-emitted electrons.

According to another aspect, a method of cleaning an emitting surface of a field emitter is provided. This method comprises the steps of providing a field emitter with an emitting surface and an electron source adapted for illuminating the emitting surface, and illuminating the emitting surface of the field emitter with an electron beam generated by the electron source.

Thus, a cleansing method is provided which does not require suspension of the operation of the emitter. Furthermore, the above described method can be combined with conventional flashing to prolong the intervals between subsequent conventional flashing processes. Thus, the efficiency of the charged particle beam apparatus is improved.

### BRIEF DESCRIPTION OF THE DRAWINGS

Some of the above indicated and other more detailed aspects of the invention will be described in the following description and partially illustrated with reference to the figures. Therein:
- Fig. 1: shows a field emitter arrangement according to an embodiment of the present invention.
- Fig. 2: shows a field emitter arrangement according to another embodiment of the present invention.
- Fig. 3: shows the field emitter arrangement of Fig. 2 in another mode of operation.
- Fig. 4: shows a field emitter arrangement according to an embodiment of the present invention, wherein a focusing lens is provided.
- Fig. 5: shows a field emitter arrangement according to an embodiment of the present invention having a plurality of electron sources.
- Fig. 6: shows a field emitter arrangement according to an embodiment of the present invention, wherein a beam separation device is provided.
- Fig. 7: shows a field emitter arrangement according to an embodiment of the present invention, wherein an energy filter is provided.
- Fig. 8: shows a charged particle beam apparatus with a field emitter arrangement according to an embodiment of the present invention.

### DETAILED DESCRIPTION OF THE DRAWINGS

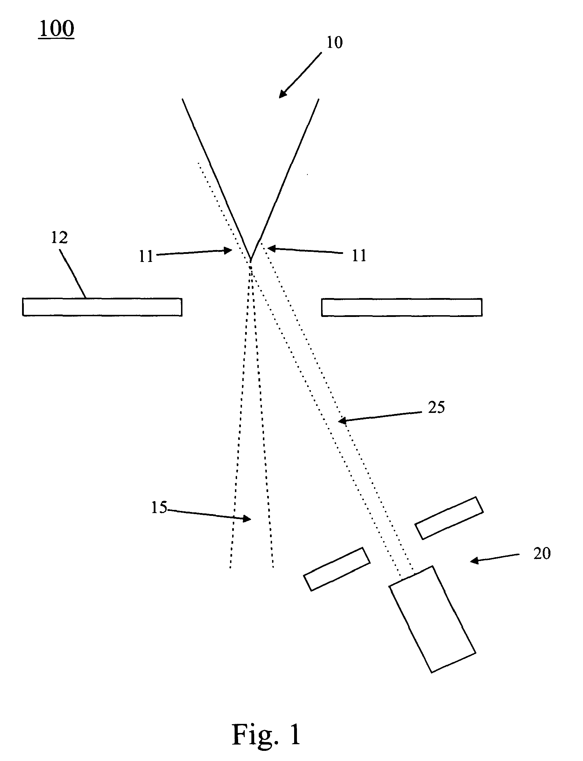

Fig. 1 shows a field emitter arrangement 100 according to an embodiment of the present invention. Therein, an emitter tip 10 of a field emission gun is provided. The emitter tip comprises an emitting surface 11 from which the charged particles, i.e. electrons in the present embodiment, are emitted. Furthermore, an extraction electrode 12 is arranged near the tip of the emitter. A voltage difference can be applied between the extraction electrode 12 and the emitter tip 10. Due to the sharply pointed shape of the emitter tip, very high field strengths build up at the pointed tip end of the emitter. The field strength is high enough to continuously extract electrons from the emitter tip 10 so that they form an electron beam 15. For example, electron beam 15 is used in wafer inspection or electron beam lithography processes.

According to the embodiment of the present invention shown in Fig. 1, there is further provided an electron source 20. Electron source 20 can be realized by a field emitter, a thermal field emitter or any other kind of electron source. Electron source 20 is adapted to illuminate the emitting surface 11 of the emitter tip 10 with an electron beam 25. The electron beam 25 enters into the emitter through the main aperture of the extraction electrode. Since electrons can be used to desorb atoms and/or molecules adsorbed at the emitting surface 11, the illumination of the emitting surface 11 with electrons generated by electron source 20 causes desorption of the adsorbed atoms and/or molecules. Thus, the emitting surface is cleansed and stable emission of the electron beam is provided. Furthermore, electron source 20 may be continuously operated so that the operation of the charged particle beam apparatus has not to be suspended for the cleansing operation.

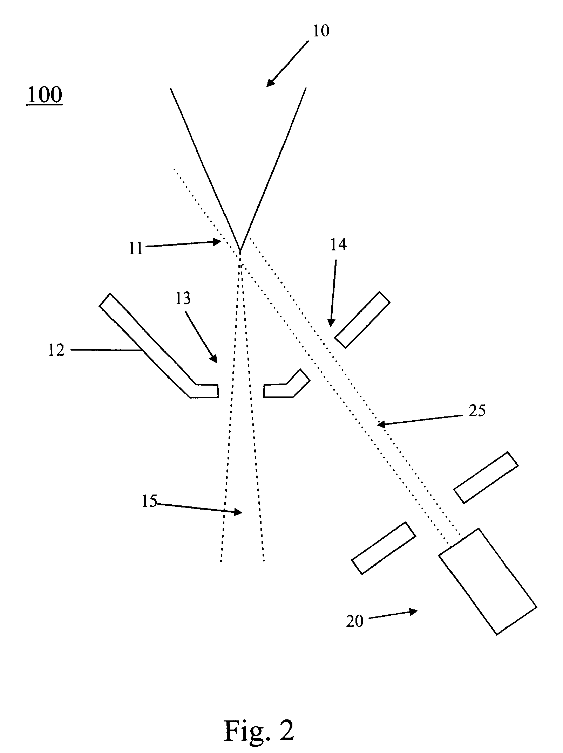

Fig. 2 shows a field emitter arrangement 100 according to another embodiment of the present invention. Therein, the extraction electrode 12 of the cold field emitter 10 has a main opening 13 for the primary electron beam 15 and an additional opening 14 for the cleansing electron beam 25. Opening 14 is located laterally with respect to the opening 13 for the primary electron beam 25. Furthermore, opening 14 is disposed between the electron source 20 and the emitting surface 11 of the field emitter so that the line of sight between the electron source and the emitting surface is not obstructed. Cleansing electron beam 25 is generated by electron source 20 and enters into the cold field emitter through opening 14. Since opening 14 is located laterally with respect to the main opening 13 and disposed between the electron source 20 and the emitting surface 11, the cleansing beam 25 also enters the emitter laterally and impinges onto the emitting surface 11 from a lateral direction. Thus, interaction between the primary electron beam 15 and the cleansing electron beam 25 can be reduced. Furthermore, the main opening 13 can be kept relatively small.

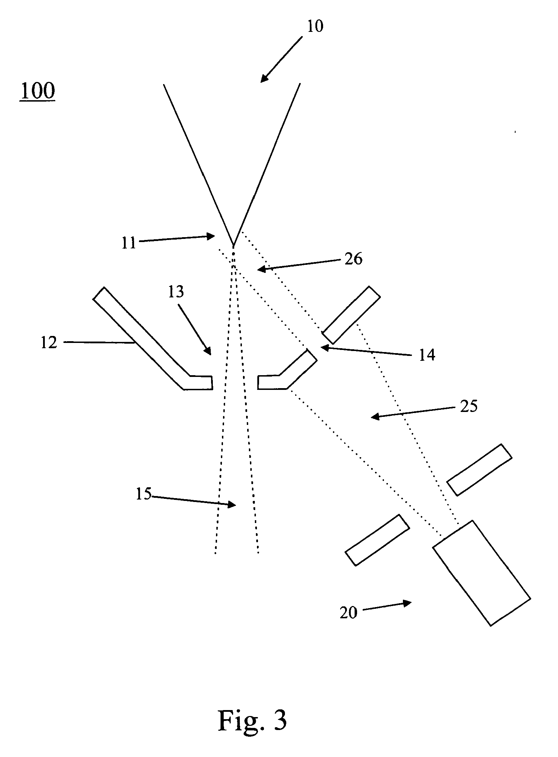

Fig. 3 shows another embodiment of the present invention. Therein, the additional opening 14 is used as an aperture for the cleansing electron beam 25. Therefore, additional opening 14 may be smaller than in the embodiment shown in Fig. 2. By using opening 14 as an aperture, the cross section of the cleansing beam 26 behind opening 14 and at the emitter surface is reduced so that essentially only the emitter tip is illuminated by cleansing beam 26.

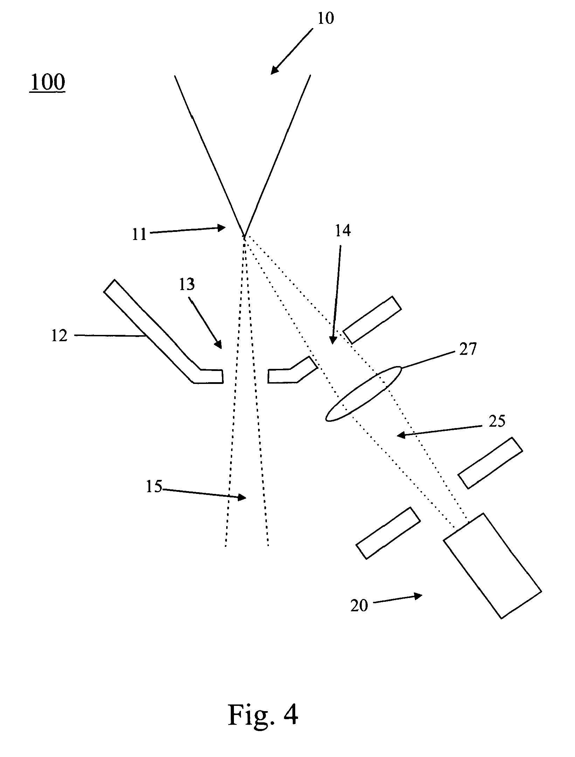

A further embodiment of the present invention is shown in Fig. 4. Therein, a lens 27 is disposed between electron source 20 and opening 14 for focusing cleansing electron beam 25 on the tip portion of field emitter 10. Thus, the full beam current density generated by electron source 20 can be used for cleaning the emitter tip. Optionally, lens 26 may be supplemented or even replaced by a deflector (not shown). Such a deflector can be used to accurately position cleansing electron beam 25 on the emitter tip. Although described with respect to the embodiment shown in Fig. 4, it should be understood that lens 26 or the deflector may also be added individually or together to the embodiments shown in Figs. 1, 2, 5, 6, 7, and 8.

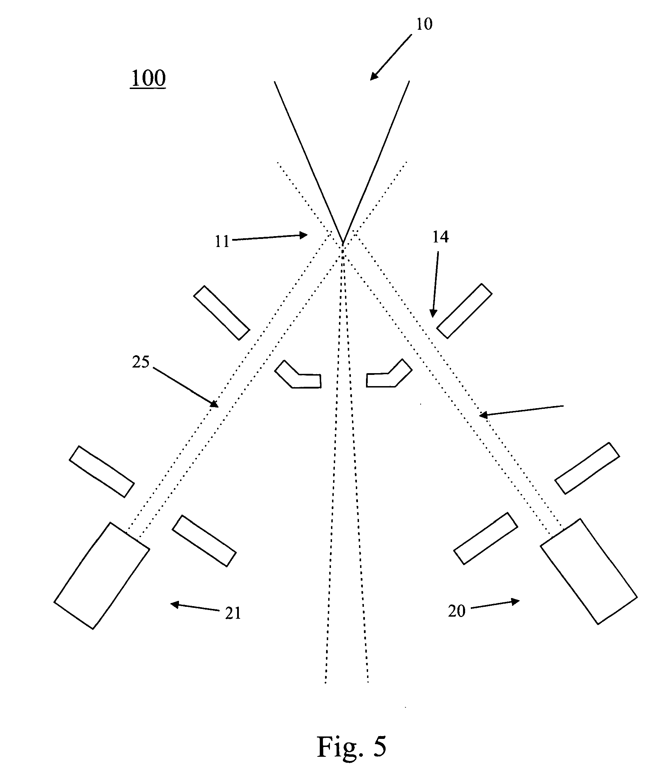

An improved embodiment of the present invention is shown in Fig. 5. Therein, a cross section of a field emitter arrangement 100 having a plurality of electron sources is shown. Compared to the embodiment shown in Fig. 2, the embodiment shown in Fig. 5 comprises a further electron source 21 which is arranged opposite to the first electron source 20 with respect to the field emitter 10. The extraction electrode of the field emitter 10 has a further opening disposed between the second electron source 21 and the emitting surface 11. A further cleansing electron beam 25 can be generated by the second electron source 21 and enter into the field emitter 10 through the further opening in the extraction electrode. Since the further electron source 21 is disposed opposite to the first electron source 20, the second electron beam impinges essentially on the opposite side of the emitting surface 11 compared to the first cleansing electron beam. Thus, the illumination uniformity on the emitting surface is improved. In addition to the embodiment described above, even further electron sources may be provided, e.g. above and below the paper plane in Fig. 5. Typically, the plurality of electron sources will be arranged on a ring around the field emitter 10. Furthermore, the electron sources can be evenly spaced on this ring so that the illumination uniformity is further improved.

Alternatively, a ring-shaped electron source (not shown) may be disposed around field emitter 10. For example, the ring-shaped emitter comprises a metal ring which is resistively heated so that thermal electron emission occurs. However, also suitable other ring-shaped electron emitters may be provided. Due to its ring shape, such an emitter provides uniform illumination of the emitting surface 11 of field emitter 10.

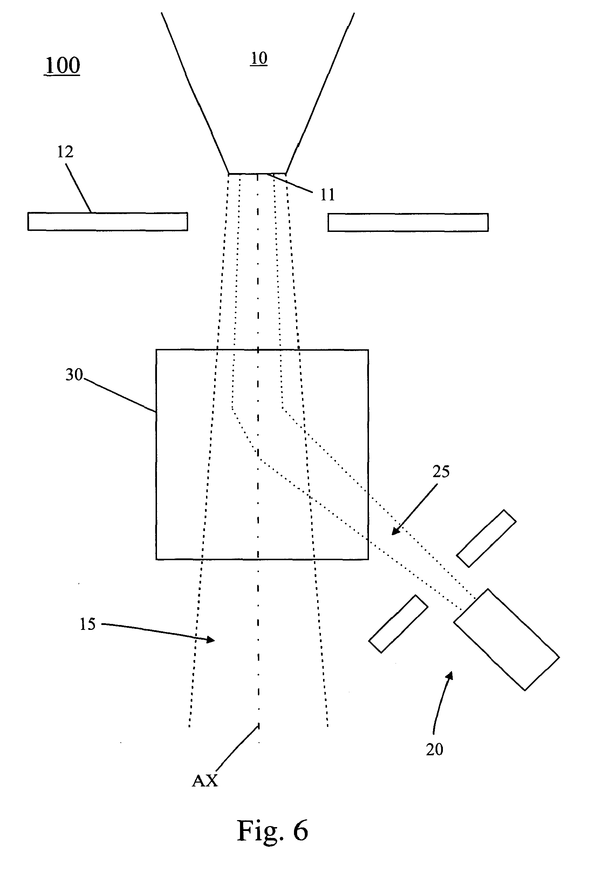

Fig. 6 shows a field emitter arrangement 100 according to a different embodiment of the present invention. Therein, a beam separation device 30 is provided which is adapted to redirect the cleansing electron beam 25 onto the emitting surface 11 of the field emitter 10. The beam separation device 30 can be realized by a magnetic dipole, a magnetic sector field of a Wien filter or any other suitable means. The beam separation device 30 is adapted that it influences essentially only the cleansing beam 25 but not the primary electron beam 15. The cleansing electron beam 25 is generated by an electron source 20 located laterally with respect to the field emitter 10. Accordingly, the cleansing electron beam 25 enters laterally into beam separation device 30. Within the beam separation device 30, the cleansing electron beam 25 is redirected in a direction coaxial with the optical axis AX of the field emitter 10. The redirected cleansing beam 25 enters the emitter through the opening for the primary beam and impinges essentially normal onto the emitting surface 11. Thus, only the emitting portion of field emitter 10 is illuminated so that the beam current density of cleansing beam 25 can be kept small. Furthermore, beam separation device 30 allows full control of cleansing electron beam 25 so that it can be focused and accurately positioned on the emitter tip.

For example, when a Wien filter is used as a beam separation device the dipole fields of the Wien filter essentially cancel each other for the primary beam. Therefore, the primary beam is only weakly influenced by the Wien filter. However, since the electrons of cleansing beam 25 travel in a direction opposite to the direction of the electrons in primary beam 15, the dipole fields of the Wien filter add together and strongly influence cleansing beam 25. Thus, cleansing beam 25 may be effectively controlled by the Wien filter without interfering with primary beam 15.

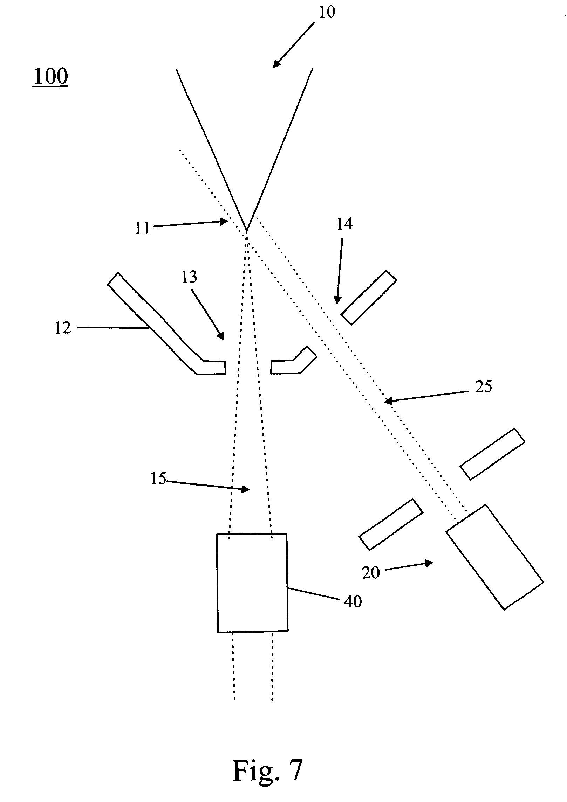

Fig. 7 shows a field emitter arrangement 100 according to a further embodiment of the present invention. Therein, an energy filter 40 is provided. Such an energy filter 40 can be realized, e.g. by a Wien filter. Some of the electrons contained in the cleansing beam 25 will produce secondary electrons at the emitting surface. However, such secondary electrons will typically have a higher energy and broader energy distribution than the field emitted electrons produced by field emitter 10. Therefore, they can be easily separated from the primary electron beam 15 by means of the energy filter 40.

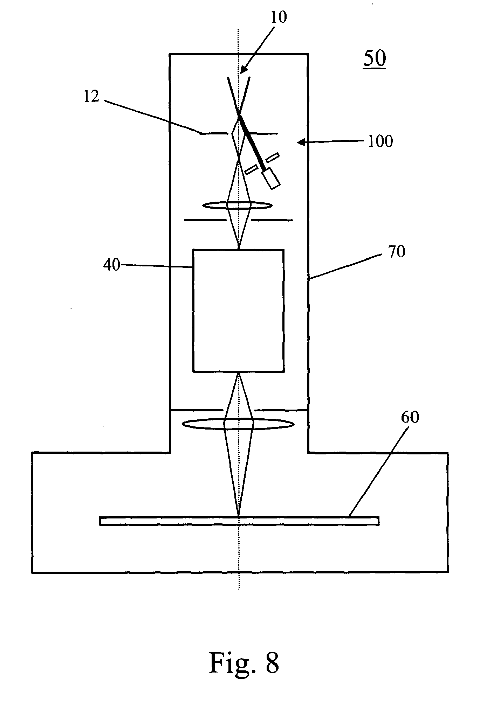

Fig. 8 shows a charged particle apparatus equipped with an emitter arrangement according to an embodiment of the present invention. Therein, the field emission gun 10, 12, the electron source 20, the energy filter 40 and a specimen 60 to be inspected are disposed within a vacuum-tight column 70. The field emission gun 10, 12 generates an electron beam which is focused onto the specimen 60 by electron optical lenses. During operation of the field emission gun, the electron source 20 illuminates the emitting surface of the emitter tip so that adsorbed atoms and/or molecules desorb there from. Thus, continuous cleansing of the emitting surface and, accordingly, continuous stable emission of the field emitter are provided.

Having thus described the invention in detail, it should be apparent for a person skilled in the art that various modifications can be made in the present invention without departing from the spirit and scope of the following claims.

## Claims

1. A field emitter arrangement (100), comprising:
a field emitter (10) having an emitting surface (11), said field emitter (10) being adapted to generate a primary beam (15) of charged particles, and
at least one electron source (20) adapted to illuminate the emitting surface (11) of the field emitter (10).

2. The field emitter arrangement (100) according to claim 1, wherein the at least one electron source (20) is a ring-shaped emitter around an extractor electrode (12) of the field emitter (10).

3. The field emitter arrangement (100) according to claim 1, wherein the at least one electron source comprises a concentrated electron emitter (20).

4. The field emitter arrangement (100) according to claim 3, wherein an extractor electrode (12) of the field emitter has an opening (14) located between the concentrated electron emitter (20) and the emitting surface (11) of the field emitter (10).

5. The field emitter arrangement (100) according to claim 3 or 4, further comprising at least one further concentrated electron emitter (22).

6. The field emitter arrangement (100) according to claim 5, wherein the extractor electrode (12) comprises a further opening (14) located between the at least one further concentrated emitter (22) and the emitting surface (11) of the field emitter (10).

7. The field emitter arrangement (100) according to claim 5 or 6, wherein a plurality of electron emitters (20, 22) is arranged in a ring-like pattern around the emitting surface (11).

8. The field emitter arrangement (100) according to any of the preceding claims, wherein the at least one electron source (20) and the field emitter (10) are integrated to form a single component.

9. The field emitter arrangement (100) according to any of the preceding claims, being further adapted such that an electron beam (25) generated by the at least one electron source (20) impinges on the emitting surface (11) in a direction essentially normal to the emitting surface (11).

10. The field emitter arrangement (100) according to claim 9, further comprising a beam separation device (30) for redirecting the electron beam (25) generated by the at least one electron source (20).

11. The field emitter arrangement (100) according to claim 10, wherein the beam separation device (30) redirects the electron beam (25) so that the electron beam (25) is essentially coaxial with the optical axis (AX) of the field emitter (10).

12. The field emitter arrangement (100) according to any of the preceding claims, wherein the electron source (20) is a thermal emitter, a cold field emitter or a photo emitter.

13. The field emitter arrangement (100) according to any of the preceding claims, wherein the at least one electron source (20) is controllable so that the average electron energy within the electron beam (25) generated by the at least one electron source (20) is variable.

14. The field emitter arrangement (100) according to any of the preceding claims, wherein the beam current density of the cleansing electron beam (25) generated by the at least one electron source (20) is adapted such that the production rate of secondary electrons generated by the cleansing electron beam (25) is lower than the rate of field-emitted electrons generated by field emission from the field emitter (10).

15. The field emitter arrangement (100) according to any of the preceding claims, further comprising an energy filter (40) for removing secondary electrons generated at the emitting surface by the cleansing electron beam (25) from a primary electron beam (15) generated by the field emitter (10).

16. The field emitter arrangement (100) according to claim 10 or 11 and 15, wherein the beam separation device and the energy filter are integrally formed.

17. The field emitter arrangement (100) according to any of the preceding claims, wherein the field emitter (10) is a field emitter of a field emitter array.

18. A charged particle beam apparatus (50) comprising a field emitter arrangement (100) according to any of claims 1 to 17.

19. A method of cleaning an emitting surface of a field emitter, comprising the steps of:
(a) providing a field emitter with an emitting surface and an electron source adapted for illuminating the emitting surface, and
(b) illuminating the emitting surface of the field emitter with an electron beam generated by the electron source.

20. The method according to claim 19, further comprising the step of removing photo-emitted electrons from an electron beam generated by the field emitter.

21. The method according to claim 19 or 20, further comprising the step of adjusting the beam current density of the cleansing electron beam generated by the at least one electron source such that the production rate of secondary electrons generated by the cleansing electron beam is lower than the rate of field-emitted electrons generated by field emission from the field emitter.
